# EUROPÄISCHE PATENTSCHRIFT

(11) **EP 1 774 585 B1**
(45) Veröffentlichungstag und Bekanntmachung des Hinweises auf die Patenterteilung: **10.09.2008**
(21) Anmeldenummer: 05752095.9
(22) Anmeldetag: 01.06.2005
(51) Int. Cl.: H01L 21/677, B65G 54/02

(54) **PROZESSSYSTEM SOWIE VORRICHTUNG ZUM TRANSPORT VON SUBSTRATEN**
PROCESS SYSTEM AND DEVICE FOR TRANSPORTING SUBSTRATES
SYSTEME DE TRAITEMENT, ET DISPOSITIF POUR TRANSPORTER DES SUBSTRATS

(30) Priorität: 02.08.2004 DE 102004037622
(43) Veröffentlichungstag der Anmeldung: 18.04.2007
(73) Patentinhaber: Leybold Optics GmbH, 63755 Alzenau (DE)
(72) Erfinder: RÖDER, Mario, 63571 Gelnhausen (Roth) (DE); CASPARI, Andreas, 63500 Seligenstadt (DE); KLESEN, Cristof, 64397 Modautal (DE)
(74) Vertreter: Pohlmann, Bernd Michael
(86) Internationale Anmeldenummer: PCT/EP2005/005897
(87) Internationale Veröffentlichungsnummer: WO 2006/015636

(56) Entgegenhaltungen:
- EP-A- 0 346 815
- US-B1- 6 361 268

## Beschreibung

Die Erfindung bezieht sich auf ein Prozesssystem sowie auf eine Vorrichtung zum Transport von Substraten gemäß den Oberbegriffen der unabhängigen Patentansprüche.

Für die Herstellung von optischen Displays werden zunehmend größere Substrate gefordert. Derartige Displays finden Anwendung vor allem bei kleinen und mittelgroßen Anzeigesystemen für beispielsweise Handys, DVD-Player, Notebooks, TV-Geräte, Autoradios oder im industriellen Einsatz. Gegenwärtig dominieren mit über 80 % Flüssigkeitskristall-Displays, während alternative Fertigungsverfahren für Plasma-Displays mit gegenwärtig 15 % und organische Leuchtdioden mit gegenwärtig 2 % schon bereitstehen. Insbesondere bei den genannten alternativen Fertigungsverfahren entstehen erhöhte Anforderungen an die Prozesssicherheit zur Erreichung einer hohen Gleichmäßigkeit der Oberflächenbearbeitung, insbesondere der Beschichtung der Substrate, die mit wachsender Substratgröße und zunehmendem Substratgewicht bisher nur mit Schwierigkeiten erreichbar sind.

Aus der EP 0346815 A2 ist ein Transportsystem für eine Vakuumanlage mit Trägermitteln und Transportmitteln für ein zu verarbeitendes Material. Die Transportmittel umfassen eine aktive magnetische Lagerung mit einem im wesentlichen quaderförmigen Lagerstator und einem diesen teilweise umschließenden Lagerrotor. Der Lagerstator weist Elektromagneten auf, die mit zugeordneten ferromagnetischen Elementen des Lagerrotors zur Erzeugung eines magnetischen Tragfeldes zusammenwirken. Eine prozesssichere Regelung der magnetischen Lagerung bei dem bekannten System ist aufgrund der konstruktionsbedingten weichen Rotordynamik aufwendig.

Aus der DE 102 47 909 A1 ist ferner eine Vorrichtung zum Transport von Substraten in Form eines berührungslos gelagerten und berührungslos angetriebenen, gestoppten und positionierten Conveyor-Systems bekannt. Das System ist passiv auf zwei Tragleisten magnetisch gelagert. Der Antrieb zur Beschleunigung und Verzögerung erfolgt durch lineare Asynchronmotoren in Lang- oder Kurzstatorausführung. Das Anhalten wird mittels einer Wirbelstrombremse realisiert, die durch einen Hubmechanismus in Eingriff gebracht werden kann. Die Positionierung erfolgt durch im Carrier befindliche Permanentmagnete. Ferner ist eine Querstabilisierung vorgesehen, wobei beidseits des Carriers ein Stahlband entlang der Fahrstrecke angeordnet ist, dem am Carrier zwei bis vier elektrisch erregte Magnetsysteme gegenüberstehen. Der Antrieb erfolgt berührungslos dadurch, dass sich entlang der Fahrstrecke Statoren von Linearmotoren befinden, die in der gewünschten Bewegungsrichtung ein magnetisches Wanderfeld erzeugen. Der Carrier weist an seiner Unterseite, dem Stator gegenüberstehend, das üblicherweise aus Aluminium bestehende Sekundärteil des Linearmotors auf. Über diesem Sekundärteil ist als magnetischer Rückschluss eine massive Stahlplatte angeordnet, über die sich der magnetische Fluss des Stators schließen kann und dadurch einen kleinen Luftspalt für den Statorfluss gewährleistet ist.

Aufgabe der vorliegenden Erfindung ist die Schaffung eines kompakten und prozesssicheren Prozesssystems sowie einer Vorrichtung zum Transport von Substraten in einer Beschichtungsprozessstraße, insbesondere für großflächige, dünne Substrate, wobei ein Substrat zwischen verschiedenen Prozessstationen in einer Beschichtungsprozessstraße mit hoher Prozesssicherheit und Dynamik bewegbar ist.

Diese Aufgabe wird erfindungsgemäß mit den Merkmalen der unabhängigen Patentansprüche gelöst. Das erfindungsgemäße Prozesssystem beinhaltet eine Vorrichtung zum Transport von Substraten auf einem Transportpfad, wobei die Vorrichtung ein Lagermodul und ein Antriebsmodul aufweist und das Lagermodul einen Lagerstator mit als Elektromagneten ausgebildeten Aktoren und eine Lagerrotor mit einem Ferromagnetbauteil aufweist. Durch zumindest zwei beabstandet zueinander angeordnete Aktoren ist ein Aktorpaar mit einem zugeordneten Spaltbereich gebildet, wobei eine aktive magnetische Lagerung des Lagerrotors in dem Spaltbereich vorgesehen ist. Zur aktiven magnetischen Lagerung ist eine Lageregelung mit Abstandssensoren vorhanden.

Die magnetische Lagerung des Lagerrotors in dem Spaltbereich führt zu einer Versteifung der Dynamik des erfindungsgemäßen Lagermoduls im Vergleich zum Stand der Technik und einer verbesserten Rotordynamik. Dadurch kann das Lagermodul auch mit sehr schweren und großen Substraten, beispielsweise Scheiben in Quadtratmeter-Abmessungen, insbesondere sicher durch Schleusen in verschiedene Kammern der Beschichtungsprozessstraße geführt werden, ohne dass ein Abkippen zu einem Verhaken des Transportmoduls oder zu einer Beschädigung des Substrats führt. Der Prozess wird dadurch vereinfacht und auch beschleunigt. Bedienungspersonal braucht manuell nicht einzugreifen, um das Substrat aus einer Prozesskammer auszuschleusen und in die nächstfolgende einzuschleusen und wieder in den Transportpfad einzuhängen. Der Transportpfad ist vorzugsweise, insbesondere in Schleusen in der Beschichtungsprozessstraße unterbrochen, welche z.B. Kammern mit unterschiedlichen Druckstufen oder Atmosphären voneinander luftdicht trennen. Zur Erzielung einer besonders stabilen Lagerung ist der Lagerrotor vorzugsweise beidseits von je zwei sich gegenüberliegenden Aktoren bzw. Elektromagneten gehalten.

Neben ihren gattungsgemäßen Merkmalen weist die erfindungsgemäße Vorrichtung zum Transport von Substraten die Merkmale auf, dass durch zumindest zwei beabstandet zueinander angeordnete Aktoren ein Aktorpaar mit einem zugeordneten Spaltbereich gebildet ist und eine aktive magnetische Lagerung des Lagerrotors in dem Spaltbereich vorgesehen ist.

Die Vorrichtung befindet sich innerhalb eines Gehäuses, das bevorzugt aus Metall gebildet ist. Damit kann eine elektromagnetische Verträglichkeit (EMV-Schutz) beispielsweise gegen Kathoden und/oder sonstige mit Hochfrequenz betriebenen Elemente in Beschichtungskammern und/oder Ätzkammern und/oder Reinigungskammern der Beschichtungsprozessstraße erreicht werden. Das Gehäuse ist bevorzugt wassergekühlt.

In einer günstigen Ausgestaltung ist ein Fanglager zum Halten des Lagerrotors bei Fehlfunktionen der Regelung oder bei Stromausfall vorgesehen. Diese ist vorzugsweise an Innenwänden im Gehäuse der Vorrichtung angeordnet, beispielsweise als Bund oder Absatz, auf dem sich der Lagerrotor beim Absinken abstützen kann, oder als Zapfen, der in korrespondierende Ausnehmungen im Lagerrotor eingreift und auf dem sich der Lagerrotor im Fehlerfall abstützen kann.

Ferner kann optional auch ein Stabilisatormodul oder Stabilisatoreinrichtung zur aktiven und/oder passiven Querlagenstabilisierung vorgesehen sein, wobei zur aktiven Querlagenstabilisierung wenigstens einen Abstandssensor für eine Abstandsregelung vorgesehen ist.

Zwischen Carrierkopf und Carrier kann ein Schwingungsdämpfer oder eine Vorrichtung zur aktiven oder passiven Schwingungsisolation angeordnet sein. Damit wird vorteilhaft das Substrat vom Carrierkopf entkoppelt und ggflls bereits eine Querlagenstabilisierung erreicht.

Der modulare Aufbau erlaubt eine vereinfachte Installation und Wartung, was besonders bei fabrikmäßigen Prozessen, insbesondere bei hochpräzisen Beschichtungsprozessen von großflächigen Substraten wie etwa optischen Displays und dergleichen, kostensparend ist. Damit können auch Substrate sicher und positionsgenau transportiert werden, welche Abmessungen von mehr als 1 x 1 m² und typische Dicken von weniger als 100 µm aufweisen, und die wenigstens zeitweise mit beträchtlichen Geschwindigkeiten von mehr als 1 m/s transportiert werden.

Zweckmäßigerweise umfasst das Antriebsmodul eine magnetische Beschleunigungsvorrichtung, die als flacher Linearmotor ausgebildet ist. Der Linearmotor kann einen Einfachstator aufweisen; alternativ kann der Linearmotor einen Doppelstator aufweisen. Ferner kann der Linearmotor ein Asynchronmotor sein. Optional kann ein Synchronmotor eingesetzt werden. Es versteht sich, dass der Linearmotor auch durch einen zylindrischen Linearmotor gebildet sein kann.

Alternativ kann ein vorzugsweise magnetischer oder pneumatischer Pulsantrieb vorgesehen sein.

Das Antriebsmodul kann eine Einrichtung zur Beschleunigung in einem Gravitationsfeld aufweisen, insbesondere einen Transportweg mit Gefälle. Zweckmäßigerweise wird mittels magnetischer oder elektromagnetischer Mittel gebremst.

In einer bevorzugten Ausgestaltung weist das Antriebsmodul einen T-förmigen Stator und einen U-Profilträger auf, in den der Statorteil mit einem ersten Längsschenkel eingreift und mit einem Querschenkel den U-Profilträger an seinem offenen Ende überdeckt. Ein Luftspalt zwischen dem Querschenkel und dem offenen Ende des U-Profilträgers kann größer ausgebildet sein als ein Luftspalt zwischen den Ferromagnetbauteilen des Lagerrotors und den Elektromagneten. Bevorzugt ist der U-Profilträger zwischen Gehäusen zweier der Elektromagnete angeordnet, wobei ein Luftspalt zwischen den Gehäusen und einer äußeren Begrenzungswand des U-Profilträgers größer ist als ein Luftspalt zwischen dem Längsschenkel und inneren Begrenzungswänden des U-Profilträgers. Damit ist Bauraum verfügbar, um bei einem Abkippen des Trägermoduls z.B. in einer Schleuse, eine Bewegungsinstabilität, insbesondere eine Nickbewegung bzw. einen Pitch auszugleichen. Der U-Profilträger weist vorzugsweise Permanentmagnete auf, falls eine Synchronmaschine zum Antrieb eingesetzt wird, oder ist zweckmäßigerweise als unmagnetische Metallschiene gebildet, insbesondere aus Aluminium oder einer Aluminiumlegierung, falls eine Asynchronmaschine eingesetzt wird.

In einer weiteren günstigen Ausgestaltung sind Lagermodul, Antriebsmodul und ggflls. Stabilisatormodul hinter einer Abschirmung zu einem Prozessraum angeordnet. Die Abschirmung kann optisch dicht ausgebildet sein, so dass eine Kontamination der Module durch Beschichtungsmaterial in Prozesskammern unterbunden werden kann.

Das Beschichtungsmaterial kann unter beliebigen Einfallswinkeln auf die optisch dichte Abschirmung treffen, ohne wesentlich hinter die Abschirmung gelangen zu können. Gleichzeitig sind genügend Durchbrüche in ausreichender Größe vorhanden, um ein Evakuieren des modulseitigen Raums hinter der Abschirmung zu ermöglichen. Es wird eine vorteilhafte Entkopplung der Module vom Substrat erreicht. Das Substrat kann verschiedensten Behandlungsverfahren unterzogen werden, beispielsweise Erhitzen durch Strahlungswärme, ohne dass die Module eine wesentliche Beeinflussung erfahren. Besonders bei einem Beschichtungsverfahren des Substrats, insbesondere bei plasmaunterstützten wie Kathodenzerstäubung oder plasmaunterstützten CVD-Verfahren (chemical vapor deposition), bei denen wegen des relativ hohen Partialdrucks während der Deposition Beschichtungsmaterial unerwünschterweise auch außerhalb zu beschichtender Bereiche, insbesondere auch hinter Blenden, niedergeschlagen wird, verhindert die optisch dichte Abschirmung eine Kontamination der Module. Vorteilhaft wird vermieden, dass schmale Luftspalten in den Modulen mit Beschichtungsmaterial zugesetzt werden und/oder sich bildende parasitäre Beläge abblättern und die Prozesskammern kontaminieren oder Material solcher Beläge in andere Prozessbereiche verschleppt werden. Aufwendige Reinigungsschritte oder gar ein Ersatz der Module können vermieden werden. In einer günstigen Ausgestaltung kann die Abschirmung wenigstens teilweise an dem beweglichen Carrierkopf angeordnet sein.

Die Abschirmung ermöglicht weiterhin eine Entkopplung hinsichtlich der Temperatur des Substrats und/oder der Beschichtungskammern und/oder möglicherweise vorhandenen Beschichtungsquellen, indem es als Strahlungsschutz gegen Wärmestrahlung dient. Dies kann vorteilhaft durch eine Kühlung im Bereich der Module, beispielsweise von Spulen und Spulenträgern, unterstützt werden. Ebenso kann die Abschirmung mit Kühlmitteln versehen sein. Zweckmäßig ist, eine Kühleinrichtung der Module mit einer Kühleinrichtung für die Abschirmung zu kombinieren. Der von der Abschirmung geschützte Bereich, in dem die Module angeordnet sind, erhält vorteilhaft nur höchstens 40% der Strahlungswärme, bevorzugt höchstens 30%, besonders bevorzugt höchstens 20%, ganz besonders bevorzugt höchstens 10% der Strahlungswärme, die auf das Substrat einwirkt, während dieses vom Lagermodul transportiert und in Prozesskammern verschiedenen Behandlungsprozessen unterzogen wird.

Die erfindungsgemäße Vorrichtung ermöglicht einen variablen Aufbau, der sich leicht an gegebene Rahmenbedingungen einer Prozessstraße anpassen lässt.

In einer günstigen Ausgestaltung ist das Substrat hängend transportierbar. Dadurch können unvorteilhafte Verbiegungen und eine mechanische Belastung des Substrats beim Transport mit der Vorrichtung vermieden werden. Das Substrat ist vorzugsweise unterhalb des Lagermoduls angeordnet. Alternativ kann das Substrat auch oberhalb des Lagermoduls angeordnet sein, indem die Vorrichtung in umgekehrter Reihenfolge kopfüber aufgebaut wird. Dadurch wird eine mechanische Belastung von Halteelementen der Vorrichtung verringert und der Schwerpunkt der Vorrichtung nach unten verlegt, was sich bei schwingungsempfindlichen Anlagen oder in schwingungsempfindlichen Umgebungen vorteilhaft auswirken kann. Ferner kann vermieden werden, dass Beläge auf bewegten Teilen, die mit der Zeit durch Beschichtungsvorgänge entstehen, durch die Bewegung auf das Substrat oder auf Beschichtungsquellen fallen und diese kontaminieren.

Nachfolgend wird die Erfindung anhand von Zeichnungen näher beschrieben, aus denen sich auch unabhängig von der Zusammenfassung in den Patentansprüchen weitere Merkmale, Einzelheiten und Vorteile der Erfindung ergeben.

Es zeigen in schematischer Darstellung:
- Figur 1: schematisch einen Ausschnitt einer Beschichtungsprozessstraße mit einem an Schleusen unterbrochenen Transportpfad,
- Figur 2: einen Querschnitt durch eine erfindungsgemäße Vorrichtung.
- Figur 3: eine alternative Ausgestaltung der erfindungsgemäßen Vorrichtung in einer so genannten 45°-Konfiguration.

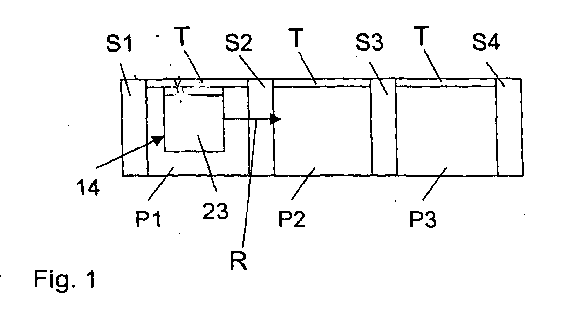

Figur 1 zeigt schematisch einen Ausschnitt einer Beschichtungsprozessstraße mit Prozesskammern P1, P2, P3 und Schleusen S1, S2, S3, S4 sowie einem Transportpfad T, der an den Schleusen unterbrochen ist. Die Prozesskammern P1, P2, P3 können Reinigungskammern, Plasmabehandlungskammern, Ätzkammern, Beschichtungskammern, Heizkammern und dergleichen sein. In der Prozesskammer P1 ist ein Substrat 23 mittels eines Carrier 14 an der erfindungsgemäßen Vorrichtung befestigt, wobei die Vorrichtung wenigstens einen Lagermodul mit einem Lagerstator und einem aktiv magnetisch gelagerten Lagerrotor und einen Antriebsmodul umfasst. Es versteht sich, dass für die aktive magnetische Lagerung eine Regelungsvorrichtung mit Abstandssensoren vorgesehen ist, die zur Vereinfachung der Darstellung jedoch nicht in den Zeichnungen gezeigt ist.

Das Lagermodul weist einen Lagerstator mit als Elektromagneten ausgebildeten Aktoren und einen Lagerrotor mit einem Ferromagnetbauteil auf. Erfindungsgemäß ist durch zumindest zwei beabstandet zueinander angeordnete Aktoren ein Aktorpaar mit einem zugeordneten Spaltbereich gebildet und eine aktive magnetische Lagerung des Lagerrotors in dem Spaltbereich vorgesehen.

Bevorzugt ist vorgesehen, dass der Lagerstator zumindest zwei mit einem Abstand zueinander angeordnete Aktorpaare mit jeweils einem zugeordneten Spaltbereich aufweist und der Lagerrotor mit seinem Ferromagnetbauteil beidseitig in die Spaltbereiche eingreift. Entlang der Bewegungsrichtung auf dem Transportpfad ist eine Mehrzahl von Aktorpaaren vorgesehen, durch die eine Segmentbildung des Lagerstators erfolgt. Um eine Lagestabilität des Lagerrotors zu gewährleisten, ist vorgesehen, dass jeweils vier Aktorpaare einen Lagerrotor gegebener Länge zugeordnet sind. In einer bevorzugten Ausführungsform der Erfindung ist vorgesehen, dass für einen Lagerrotor sechs oder mehr Aktoreinheiten an der Kompensation der Gewichtskraft beteiligt sind. Damit ist ein Betrieb der Anlage mit einem ausgefallenen Aktor möglich. Vorzugsweise ist die Länge eines Lagerrotors mindestens gleich der Länge eines Lagerstatorsegments.

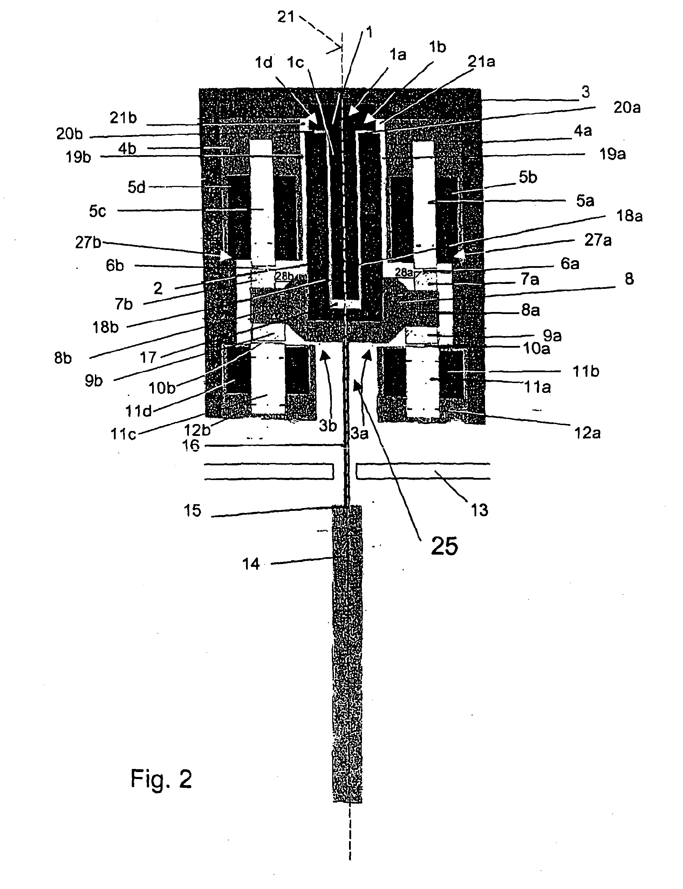

In Figur 2 ist eine bevorzugte Vorrichtung zum Transport eines Substrats erläutert, wie sie insbesondere in einem bevorzugten Prozesssystem zum Transport des Substrats auf einem Transportpfad in einer Beschichtungsprozessstraße mit Vakuumbeschichtungsverfahren wie PVD oder CVD eingesetzt werden kann.

Die Vorrichtung weist in ihrem Kopfbereich ein Gehäuse 3 auf. Das Gehäuse 3 ist vorzugsweise wassergekühlt. Der Lagerrotor 8 ist als Carrierkopf des Carriers 14 ausgebildet. Durch das Antriebsmodul 1 ist eine Bewegung des Lagerrotors 8 senkrecht zur Bildebene bewirkbar.

Das Antriebsmodul 1 umfasst eine T-förmige magnetische Beschleunigungseinrichtung 1a, die als Synchronmaschine oder auch als Asynchronmaschine ausgebildet sein kann. Ein Stator 1b greift mit seinem Längsschenkel 1 c in einen U-Profil-Träger 2 ein und überdeckt mit einem Querschenkel 1d den U-Profilträger 2 an seinem offenen Ende. Alternativ kann ein vorzugsweise magnetischer oder pneumatischer Pulsantrieb vorgesehen sein.

Am entgegengesetzten Ende des U-Profilträgers 2 ist der Carrierkopf 8 mit einem daran befestigten, sich vom Carrierkopf 8 weg erstreckenden Carrier 14 angeordnet. Zwischen Carrierkopf 8 und Carrier 14 ist vorzugsweise ein Verbindungselement 16 vorgesehen, das an eine Carrierbefestigung 15 am Carrier 14 angreift. Das Verbindungselement 16 ist vorzugsweise aus Blech gebildet und entkoppelt schwingungsmäßig oder dämpft den Carrier 14 und damit das Substrat vom Carrierkopf 8.

Das Lagermodul 25 weist vorzugsweise eine aktive und/oder passive Querlagenstabilisierung auf. Hierfür ist eine Stabilisatoreinrichtung vorgesehen. Eine passive Querlagenstabilisierung wird erreicht, wenn das Verbindungselement 16 unter Berücksichtigung des Trägheitsmoments des Carriers derart ausgebildet ist, dass eine Schwingungsisolation erreicht wird. Hierzu wird das Systemverbindungselement 16 und Carrier 14 derart ausgelegt, dass die Haupteigenfrequenzen niedriger als typische bei der Bewegung des Rotors auftretende Frequenzen liegen. Vorzugsweise weist das Verbindungselement 16 eine relativ geringe Biegesteifigkeit auf. Typische Frequenzen der Rotorbewegung liegen bei 100 Hz, während die bevorzugten Eigenfrequenzen des Systemverbindungselements 16 und Carrier 14 bei 5 Hz gewählt werden.

Alternativ oder zusätzlich sind zur aktiven Querlagenstabilisierung in der Figur 2 nicht dargestellte Elektromagnete vorgesehen, mit denen quer zur Längsachse 21 gerichtete magnetische Wirkflächen erzeugt werden können, die mit den Ferromagnetbauteilen des Lagerrotors wechselwirken. Eine entsprechende Regelung beinhaltet zumindest einen Abstandssensor. Bevorzugt, aber nicht ausschließlich, ist es vorgesehen, mit den aktiven Dämpfungsmaßnahmen ein niederfrequentes Nachschwingen des Carriers zu verhindern.

In einem Bereich zwischen dem Lagerrotor 8 und dem Carrier 14 ist eine Abschirmung 13 als Wärmeschutz vorgesehen.

Das Lagerrotor 8 ist gemäß Figur 2 beidseits zwischen zwei sich gegenüberliegenden Elektromagneten 5a und 11a bzw. 5c und 11c gehalten. Die Elektromagnete 5a, 5c sind auf Vorsprüngen 27a, 27b im Gehäuse 3 gelagert. Die Kerne der Elektromagnete 5a, 11a, 5c, 11 c sind von Spulen 5b, 11 b, 5d 11 d umgeben, wobei jeder Elektromagnet 5a, 11a, 5c, 11c von einem Gehäuse 4a, 4b, 12a, 12b umgeben ist.

Die elektromagnetischen Wirkflächen der Elektromagnete 5a, 11a bzw. 5c, 11 c, die das magnetische Schweben des Lagerrotors 8 bewirken, sind senkrecht zur Längsachse 21 angeordnet, wobei der Carrier 14 und damit das Substrat parallel zu einer Längsachse 21 angeordnet sind.

Der Lagerrotor 8 weist Halteelemente 8a, 8b auf. Jedes Halteelement 8a, 8b weist an seinen den Elektromagneten 5a, 11a, 5c, 11c zugewandten Oberflächen Ferromagnetbauteile 7a, 9a, 7b, 9b auf.

Der Lagerrotor 8 greift beidseitig mit den quer zur Längsachse 21 an Halteelementen 8a, 8b angeordneten Ferromagnetbauteilen 7a, 9a, 7b, 9b zwischen die sich gegenüberliegenden Elektromagnete 5a, 11a, 5c, 11c ein. Die dargestellte Konfiguration von Lagerrotor 8 und Elektromagneten 5a, 11a, 5c, 11c weist eine passive Querlagenpositionierung des Lagerrotors 8 relativ zu den Elektromagneten auf. In einer weiteren Ausführungsform der Erfindung ist eine aktive Querlagenpositionierung vorgesehen, für die weitere Elektromagnete und ggfls. weitere Ferromagnetbauteile sowie zumindest ein Abstandssensor vorgesehen sind.

Zweckmäßigerweise sind die Elektromagnete 5a, 5c bzw. 11a, 11c, welche den Lagerrotor umgreifen, verschieden groß ausgebildet. Auf der Unterseite des Lagerrotors 8 sind z.B. die Elektromagnete 11a und 11b mit ihrem Kern breiter als die auf der Oberseite des Lagerrotors 8 liegenden Kerne der Elektromagnete 5a, 5b. Zwischen den Elektromagneten 5a und 11a ist ein Luftspalt 28a und zwischen den Elektromagneten 5c und 11c ein Luftspalt 28b ausgebildet, in welche der Lagerrotor 8 eingreift.

Die den Elektromagneten 5a, 5c gegenüberliegenden Elemente 7a, 7b sind der Größe des Kerns der Elektromagneten angepasst und hier kleiner als die den Elektromagneten 11a, 11 c gegenüberliegenden Elemente 9a, 9b. Zwischen den Elementen 7a, 7b bzw. 9a, 9b und ihren gegenüberliegenden Elektromagneten 5a, 5c bzw. 11a, 11c sind Luftspalte 6a, 6b bzw. 10a, 10b ausgebildet.

Ein Luftspalt 17 zwischen dem freien Ende des Statorteils 1b und dem Boden des U-Profilträgers 2 ist sehr groß ausgebildet, z.B. 1 bis 3 cm, bevorzugt 1,5 bis 2,5 cm, besonders bevorzugt 2 cm. Am freien Ende des U-Profilträgers 2 ist zwischen den Stirnseiten des freien Endes und dem Querschenkel 1d ein Luftspalt 20a bzw. 20b ausgebildet.

Ein Luftspalt 20a, 20b zwischen dem Querschenkel 1d und dem offenen Ende des U-Profilträgers 2 an seinen Stirnseiten ist größer ist als ein Luftspalt 6a, 6b zwischen den Ferromagnetbauteilen des Lagerrotors 8 und den Elektromagneten 5a, 5c.

Ein Luftspalt 19a, 19b zwischen den Gehäusen 4a, 4b und einer äußeren Begrenzungswand des U-Profilträgers 2 ist größer als ein Luftspalt 18a, 18b zwischen dem Längsschenkel 1c und inneren Begrenzungswänden des U-Profilträgers 2.

Zum Halten des Lagerrotors 8 bei Fehlern der Regelung oder bei Stromausfall sind Fanglager 3a, 3b, vorgesehen, die als Absatz innerhalb des Gehäuses 3 ausgebildet ist.

Die Fanglager 3a, 3b werden jeweils durch die Gehäuse 12a, 12b der Elektromagneten 11 a, 11 c gebildet.

Selbstverständlich kann die Anordnung von Trägermodul 25, Antriebsmodul 2 und ein etwaiges Stabilisatormodul auch verschieden zu der dargestellten Anordnung ausgebildet sein. So kann das Substrat 23 statt unterhalb des Trägermoduls 25 auch oberhalb des Trägermoduls 25 angeordnet sein. Carrierkopf 8 und ein nicht dargestellter Carrierfuß, in dem der Carrier 14 bzw. das Substrat geführt oder gelagert ist, können umgekehrt zur gezeigten Darstellung angeordnet sein.

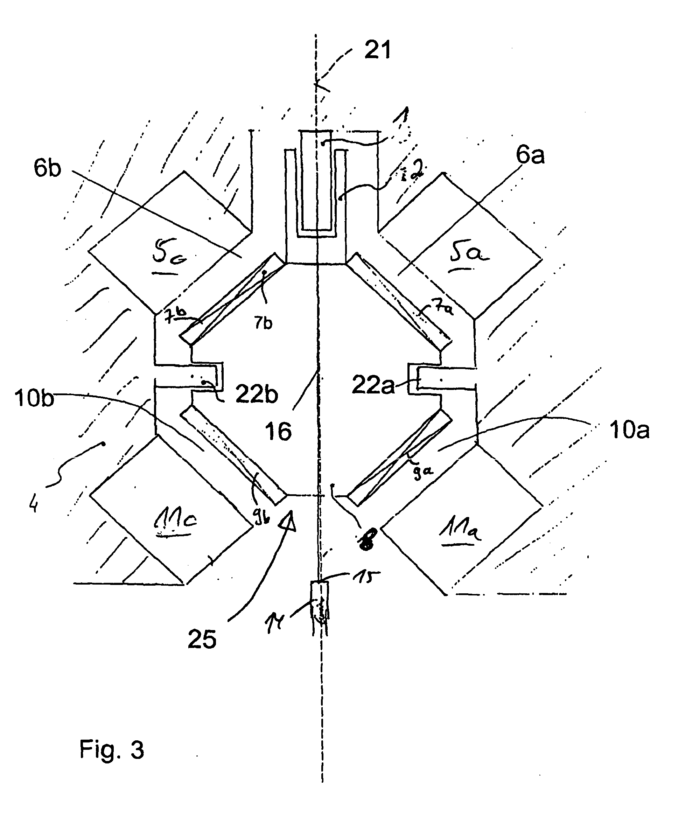

Figur 3 verdeutlicht in vereinfachter Darstellung eine alternative Ausgestaltung der erfindungsgemäßen Vorrichtung in einer Kipp-Konfiguration. Bevorzugt ist eine Konfiguration mit einer Verkippung der Elektromagnete von maximal 45°, vorzugsweise 10° bis 15° zur Längsachse 21. Gleichbleibende Elemente weisen gleiche Bezugszeichen wie in den vorhergehenden Figuren auf. Zur Erläuterung der Funktion der einzelnen Elemente wird auf die vorhergehende Beschreibung der Figuren 1 und 2 verwiesen. Die Elektromagnete 5a, 11a, 5c, 11c sind so verkippt, dass deren elektromagnetische Wirkflächen nicht mehr senkrecht zur Längsachse 21 angeordnet sind, sondern einen Winkel, vorzugsweise von weniger als 45° dazu einnehmen. Der Lagerrotor 8 weist entsprechend einen Achteck-Querschnitt auf. Fanglager 22a, 22b sind im Gehäuse 3 als Zapfen ausgebildet, die in korrespondierende Ausnehmungen des Lagerrotors 8 eingreifen. Bei einem Stromausfall oder einer Fehlfunktion der Regelung kann sich der Lagerrotor 8 auf den Fanglagern 22a, 22b abstützen. Der Lagerrotor 8 trägt an seinen den Paaren von Elektromagneten 5a, 11a bzw. 5c, 11c direkt gegenüberliegenden Stirnseiten Ferromagnete 7a, 9a bzw. 7b, 9b, mit Luftspalten 6a, 6b bzw. 10a, 10b zu den jeweilige Elektromagnet-Paaren 5a, 11a und 5c, 11c. Der Abstand zwischen den Elektromagnet-Paaren 5a, 11a bzw. 5c, 11 c ist im Gegensatz zur Anordnung in Figur 2 nicht konstant, sondern erweitert sich wegen der Verkippung zum Lagerrotor 8 hin.

### BEZUGSZEICHENLISTE

- 1: Antriebsmodul
- 1a: Beschleunigungsvorrichtung
- 1b: Statorteil
- 1c: Längsschenkel
- 1d: Querschenkel
- 2: U-Profilträger
- 3: Gehäuse
- 3a, b: Fanglager
- 4a, b: Gehäuse
- 5a, c: Elektromagnet
- 5b, d: Spule
- 6a, b: Luftspalt
- 7a, b: Ferromagnetbauteil
- 8: Lagerrotor, Carrierkopf
- 8a, b: Halteelement
- 9a, b: Ferromagnetbauteil
- 10a, b: Spalt
- 11a, c: Elektromagnet
- 12a, b: Gehäuse
- 13: Wärmeschutz
- 14: Carrier
- 15: Carrierbefestigung
- 16: Schwingungsdämpfer
- 17: Luftspalt
- 18a, b: Luftspalt
- 19a, b: Luftspalt
- 20a, b: Luftspalt
- 21: Längsachse
- 22a, b: Fanglager
- 23: Substrat
- 25: Trägermodul
- 27a,b: Vorsprung
- 28a, b: Luftspalt
- P1-P3: Prozesskammer
- S1-S4: Schleuse
- T: Transportpfad

## Patentansprüche

1. Prozesssystem mit einer Vorrichtung zum Transport von Substraten (23) auf einem Transportpfad (T), wobei die Vorrichtung ein Lagermodul und ein Antriebsmodul aufweist und das Lagermodul einen Lagerstator mit als Elektromagneten ausgebildeten Aktoren und einem Lagerrotor mit einem Ferromagnetbauteil aufweist, **dadurch gekennzeichnet, dass** durch zumindest zwei beabstandet zueinander angeordnete Aktoren ein Aktorpaar mit einem zugeordneten Spaltbereich gebildet und eine aktive magnetische Lagerung des Lagerrotors in dem Spaltbereich vorgesehen ist.

2. Prozesssystem nach Anspruch 1, **dadurch gekennzeichnet, dass** der Lagerstator zumindest zwei mit einem Abstand zueinander angeordnete Aktorpaare mit jeweils zugeordneten Spaltbereichen aufweist und der Lagerrotor mit seinem Ferromagnetbauteil beidseitig in die Spaltbereiche angreift.

3. Prozesssystem nach Anspruch 1 oder 2, **dadurch gekennzeichnet, dass** der Transportpfad (T) Unterbrechungsbereiche aufweist.

4. Prozesssystem nach Anspruch 3, **dadurch gekennzeichnet, dass** der Transportpfad (T) in dem Bereich zumindest einer Schleuse (S1, S2, S3, S4) zwischen Prozesskammern (P1, P2, P3) eine Beschichtungsprozessstrasse unterbrochen ist.

5. Vorrichtung zum Transport von Substraten (23) auf einem Transportpfad (T) mit zumindest einem Lagermodul und einem Antriebsmodul, wobei das Lagermodul einen Lagerstator mit als Elektromagneten (5a) ausgebildeten Aktoren und einen Lagerrotor mit einem Ferromagnetbauteil (9a) aufweist, **dadurch gekennzeichnet, dass** durch zumindest zwei beabstandet zueinander angeordnete Aktoren (5a) ein Aktorpaar mit einem zugeordneten Spaltbereich gebildet ist und eine aktive magnetische Lagerung des Lagerrotors in dem Spaltbereich vorgesehen ist.

6. Vorrichtung nach Anspruch 5, **dadurch gekennzeichnet, dass** der Lagerstator zumindest zwei mit einem Abstand zueinander angeordnete Aktorpaare mit jeweils einem zugeordneten Spaltbereich aufweist und der Lagerrotor mit seinem Ferromagnetbauteil beidseitig in die Spaltbereiche eingreift.

7. Vorrichtung nach Anspruch 5 oder 6, **dadurch gekennzeichnet, dass** das Lagermodul einen Carrierkopf (8) für einen Substratcarrier aufweist.

8. Vorrichtung nach zumindest einem der Ansprüche 5 bis 7, **dadurch gekennzeichnet, dass** das Antriebsmodul (1) eine magnetische Beschleunigungsvorrichtung (1a) umfasst.

9. Vorrichtung nach zumindest einem der Ansprüche 5 bis 8, **dadurch gekennzeichnet, dass** das Lagermodul (25) eine Stabilisatoreinrichtung für eine passive Querlagenstabilisierung aufweist.

10. Vorrichtung nach zumindest einem der Ansprüche 5 bis 9, **dadurch gekennzeichnet, dass** das Lagermodul (25) eine Stabilisatoreinrichtung für eine aktive Querlagenstabilisierung aufweist.

11. Vorrichtung nach zumindest einem der Ansprüche 5 bis 10, **dadurch gekennzeichnet, dass** das Antriebsmodul (1) einen T-förmigen Statorteil (1b) und einen U-Profil-Träger (2) aufweist, in den der Statorteil (1b) mit einem ersten Schenkel (1c) eingreift und mit einem Querschenkel (1d) den U-Profilträger (2) an seinem offenen Ende überdeckt.

12. Vorrichtung nach Anspruch 11, **dadurch gekennzeichnet, dass** ein Luftspalt (20a, 20b) zwischen dem Querschenkel (1d) und dem offenen Ende des U-Profilträgers (2) größer ist als ein Luftspalt (6a, 6b) zwischen den Ferromagnetbauteilen (7a, 7b) des Carrierkopfs (8) und den Elektromagneten (5a, 5c).

13. Vorrichtung nach zumindest einem der Ansprüche 11 oder 12, **dadurch gekennzeichnet, dass** der U-Profilträger (2) zwischen Gehäusen (4a, 4b) zweier der Elektromagnete (5a, 5c) angeordnet ist und ein Luftspalt (19a, 19b) zwischen den Gehäusen (4a, 4b) und einer äußeren Begrenzungswand des U-Profilträgers (2) größer ist als ein Luftspalt (18a, 18b) zwischen dem ersten Schenkel (1c) und inneren Begrenzungswänden des U-Profilträgers (2).

14. Vorrichtung nach zumindest einem der Ansprüche 5 bis 13, **dadurch gekennzeichnet, dass** eine Abschirmung (13) zwischen Trägermodul (25) und Antriebsmodul (1) und einem Prozessraum angeordnet ist.

15. Vorrichtung nach zumindest einem der Ansprüche 5 bis 14, **dadurch gekennzeichnet, dass** das Substrat (23) unterhalb des Trägermoduls (25) angeordnet ist.

16. Vorrichtung nach zumindest einem der Ansprüche 5 bis 15, **dadurch gekennzeichnet, dass** das Substrat (23) oberhalb des Trägermoduls (25) angeordnet ist.

## Claims

1. Process system comprising a device for transporting substrates (23) on a transport path (T), the device having a bearing module and a drive module and the bearing module having a bearing stator with actuators formed as electromagnets and a bearing rotor with a ferromagnet component, **characterized in that** an actuator pair with an assigned gap region is formed by at least two actuators arranged at a distance from one another and active magnetic mounting of the bearing rotor in the gap region is provided.

2. Process system according to Claim 1, **characterized in that** the bearing stator has at least two actuator pairs each with assigned gap regions, said actuator pairs being arranged at a distance from one another, and the bearing rotor engages in the gap regions on both sides with its ferromagnet component.

3. Process system according to Claim 1 or 2, **characterized in that** the transport path (T) has interruption regions.

4. Process system according to Claim 3, **characterized in that** the transport path (T) is interrupted in the region of at least one lock (S1, S2, S3, S4) between process chambers (P1, P2, P3) of a coating process line.

5. Device for transporting substrates (23) on a transport path (T) comprising at least one bearing module and a drive module, the bearing module having a bearing stator with actuators formed as electromagnets (5a) and a bearing rotor with a ferromagnet component (9a), **characterized in that** an actuator pair with an assigned gap region is formed by at least two actuators (5a) arranged at a distance from one another and active magnetic mounting of the bearing rotor in the gap region is provided.

6. Device according to Claim 5, **characterized in that** the bearing stator has at least two actuator pairs each with an assigned gap region, said actuator pairs being arranged at a distance from one another, and the bearing rotor engages in the gap regions on both sides with its ferromagnet component.

7. Device according to Claim 5 or 6, **characterized in that** the bearing module has a carrier head (8) for a substrate carrier.

8. Device according to at least one of Claims 5 to 7, **characterized in that** the drive module (1) comprises a magnetic acceleration device (1a).

9. Device according to at least one of Claims 5 to 8, **characterized in that** the bearing module (25) has a stabilizer unit for a passive transverse position stabilization.

10. Device according to at least one of Claims 5 to 9, **characterized in that** the bearing module (25) has a stabilizer unit for an active transverse position stabilization.

11. Device according to at least one of Claims 5 to 10, **characterized in that** the drive module (1) has a T-shaped stator part (1b) and a U-profile support (2) into which the stator part (1b) engages with a first limb (1c) and covers the U-profile support (2) at its open end with a transverse limb (1d).

12. Device according to Claim 11, **characterized in that** an air gap (20a, 20b) between the transverse limb (1d) and the open end of the U-profile support (2) is larger than an air gap (6a, 6b) between the ferromagnet components (7a, 7b) of the carrier head (8) and the electromagnets (5a, 5c).

13. Device according to at least one of Claims 11 or 12, **characterized in that** the U-profile support (2) is arranged between housings (4a, 4b) of two of the electromagnets (5a, 5c) and an air gap (19a, 19b) between the housings (4a, 4b) and an outer boundary wall of the U-profile support (2) is larger than an air gap (18a, 18b) between the first limb (1c) and inner boundary walls of the U-profile support (2).

14. Device according to at least one of Claims 5 to 13, **characterized in that** a shielding (13) is arranged between support module (25) and drive module (1) and a process space.

15. Device according to at least one of Claims 5 to 14, **characterized in that** the substrate (23) is arranged beneath the support module (25).

16. Device according to at least one of Claims 5 to 15, **characterized in that** the substrate (23) is arranged above the support module (25).

## Revendications

1. Système de processus comprenant un dispositif de transport de substrats (23) sur un trajet de transport (T), le dispositif présentant un module d'appui et un module d'entraînement et le module d'appui présentant un stator d'appui comprenant des actionneurs réalisés sous la forme d'électro-aimants et un rotor d'appui comprenant un composant ferromagnétique, **caractérisé en ce qu'**une paire d'actionneurs à laquelle est associée une zone d'entrefer est formée par au moins deux actionneurs espacés l'un de l'autre et un appui magnétique actif du rotor d'appui est prévu dans la zone d'entrefer.

2. Système de processus selon la revendication 1, **caractérisé en ce que** le stator d'appui présente au moins deux paires d'actionneurs disposées à une certaine distance l'une de l'autre comprenant respectivement des zones d'entrefer associées et le rotor d'appui est appliqué dans les zones d'entrefer des deux côtés avec son composant ferromagnétique.

3. Système de processus selon la revendication 1 ou 2, **caractérisé en ce que** le trajet de transport (T) présente des zones d'interruption.

4. Système de processus selon la revendication 3, **caractérisé en ce que** le trajet de transport (T) est interrompu dans la zone d'au moins un sas (S1, S2, S3, S4) entre les chambres de processus (P1, P2, P3) d'une voie de processus de revêtement.

5. Dispositif de transport de substrats (23) sur un trajet de transport (T) comprenant au moins un module d'appui et un module d'entraînement, le module d'appui présentant un stator d'appui comprenant des actionneurs réalisés sous la forme d'électro-aimants (5a) et un rotor d'appui comprenant un composant ferromagnétique (9a), **caractérisé en ce qu'**une paire d'actionneurs à laquelle est associée une zone d'entrefer est formée par au moins deux actionneurs espacés l'un de l'autre et un appui magnétique actif du rotor d'appui est prévu dans la zone d'entrefer.

6. Dispositif selon la revendication 5, **caractérisé en ce que** le stator d'appui présente au moins deux paires d'actionneurs disposées à une certaine distance l'une de l'autre comprenant respectivement une zone d'entrefer associée et le rotor d'appui est appliqué dans les zones d'entrefer des deux côtés avec son composant ferromagnétique.

7. Dispositif selon la revendication 5 ou 6, **caractérisé en ce que** le module d'appui présente une tête porteuse (8) pour un porte-substrat.

8. Dispositif selon au moins l'une des revendications 5 à 7, **caractérisé en ce que** le module d'entraînement (1) comprend un dispositif d'accélération magnétique (1a).

9. Dispositif selon au moins l'une des revendications 5 à 8, **caractérisé en ce que** le module d'appui (25) présente un dispositif de stabilisation pour une stabilisation passive de la position transversale.

10. Dispositif selon au moins l'une des revendications 5 à 9, **caractérisé en ce que** le module d'appui (25) présente un dispositif de stabilisation pour une stabilisation active de la position transversale.

11. Dispositif selon au moins l'une des revendications 5 à 10, **caractérisé en ce que** le module d'entraînement (1) présente une partie stator en forme de T (1b) et un support à profilé en U (2) dans lequel la partie stator (1b) vient en prise avec une première branche (1c) et recouvre l'extrémité ouverte du support à profilé en U (2) avec une branche transversale (1c).

12. Dispositif selon la revendication 11, **caractérisé en ce qu'**un entrefer (20a, 20b) entre la branche transversale (1d) et l'extrémité ouverte du support à profilé en U (2) est plus grand qu'un entrefer (6a, 6b) entre les composants ferromagnétiques (7a, 7b) de la tête porteuse (8) et les électro-aimants (5a, 5c).

13. Dispositif selon au moins l'une des revendications 11 ou 12, **caractérisé en ce que** le support à profilé en U (2) est disposé entre les boîtiers (4a, 4b) de deux des électroaimants (5a, 5c) et un entrefer (19a, 19b) entre les boîtiers (4a, 4b) et une paroi de délimitation extérieure du support à profilé en U (2) est plus grand qu'un entrefer (18a, 18b) entre la première branche (1c) et les parois de délimitation intérieures du support à profilé en U (2).

14. Dispositif selon au moins l'une des revendications 5 à 13, **caractérisé en ce qu'**un blindage (13) est disposé entre le module porteur (25) et le module d'entraînement (1) et une chambre de processus.

15. Dispositif selon au moins l'une des revendications 5 à 14, **caractérisé en ce que** le substrat (23) est disposé au-dessous du module porteur (25).

16. Dispositif selon l'une des revendications 5 à 15, **caractérisé en ce que** le substrat (23) est disposé au-dessus du module porteur (25).
